Europäisches Patentamt

European Patent Office

Office européen des brevets

(19)

(11) EP 0 720 728 B1

(12) **EUROPEAN PATENT SPECIFICATION**

(45) Date of publication and mention
of the grant of the patent:
**19.06.2002 Bulletin 2002/25**

(21) Application number: **94927161.3**

(22) Date of filing: **09.08.1994**

(51) Int Cl.⁷: **H03F 3/45**, H03F 3/04,
H03F 3/347, G01H 11/06

(86) International application number:
**PCT/US94/09098**

(87) International publication number:
**WO 95/05584 (23.02.1995 Gazette 1995/09)**

(54) **TWO-WIRE CONSTANT CURRENT POWERED TRANSDUCER**

KONSTANTSTROMGESPEISTER ZWEIDRAHTWANDLER

TRANSDUCTEUR DEUX-FILS A COURANT CONSTANT

(84) Designated Contracting States:
**AT BE CH DE DK ES FR GB GR IE IT LI LU MC NL
PT SE**
Designated Extension States:
**LT**

(30) Priority: **11.08.1993 US 105873**

(43) Date of publication of application:
**10.07.1996 Bulletin 1996/28**

(73) Proprietors:
- **BENTLY NEVADA CORPORATION
Minden Nevada 89423 (US)**
- **Li, Don
Houston, TX 77065 (US)**
- **Campbell, Lam
Houston, TX 77065 (US)**
- **Busch, Todd
Houston, TX 77065 (US)**

(72) Inventors:
- **LI, Don
Houston, TX 77065 (US)**
- **CAMPBELL, Lam
Houston, TX 77065 (US)**
- **BUSCH, Todd
Houston, TX 77065 (US)**

(74) Representative: **Colens, Alain
c/o Bureau Colens SPRL
rue Franz Merjay 21
1050 Bruxelles (BE)**

(56) References cited:
| | |
|---|---|
| **US-A- 3 860 481** | **US-A- 4 328 441** |
| **US-A- 4 479 093** | **US-A- 4 612 620** |
| **US-A- 4 843 344** | **US-A- 4 885 707** |
| **US-A- 4 994 693** | |

## Description

### Technical Field

This invention relates to a two-wire piezoelectric crystal velocity transducer that is designed to process a cyclic voltage acceleration signal and to output an integrated velocity response. More specifically this invention relates in general to monitoring a bearing housing or casing for structural vibration related to rotating and reciprocating machinery by the use of transducers in order to diagnose the overall condition of the machine which is correlative to maintenance.

### Background Art

Two-wire constant current powered transducers are presently using individual Field-Effect transistors (FETs) and Bipolar Junction transistors (BJTs) to process data. These circuits are heavily dependent on the characteristics of the active components, which usually have a wide range of component tolerance, such as gain, bias voltage, bias current and temperature coefficient.

Accordingly, each production unit has to be initially calibrated to incorporate those tolerances. Moreover, the optimal operating point drifts widely as a function of both temperature and age. The bandwidth is narrow (because of not having enough gain). The design is thus difficult and the labor and parts cost are high.

The following prior art reflects the state of the art of which applicant is aware and is included herewith to discharge applicant's acknowledged duty to disclose relevant prior art. It is stipulated, however, that none of these references teach singly nor render obvious when considered in any conceivable combination the nexus of the instant invention as disclosed in greater detail hereinafter and as particularly claimed.

| INVENTOR | ISSUE DATE | PATENT NUMBER |
|---|---|---|
| Bruckenstein et al. | November 4, 1975 | 3,918,005 |
| Barr | December 11,1979 | 4,178,525 |
| Peters | March 1, 1988 | 4,727,752 |
| Park et al. | February 28, 1989 | 4,807,482 |
| Alexander | March 17,1992 | 5,097,223 |
| Verheyen et al. | July 14, 1992 | 5,130,598 |
| Cox | June 27 1989 | 4,843,344 |
| Gopal et al. | January 14, 1975 | 3,860,481 |
| Nichol et al. | December 5, 1989 | 4,885,707 |

U.S. Patent No. 3,918,005 to Bruckenstein, et al. teaches the use of op-amp circuitry with automatic self-biasing wherein either a controlled current or voltage is provided at the load impedance Z connected across the inverting input and the second op-amp A2.

U.S. Patent No. 4,178,525 to Barr teaches the use of a two-wire piezoelectric acceleration transmitter for detecting and transmitting peak amplitudes of cyclic voltage developed by transducer 32 responsive to vibration.

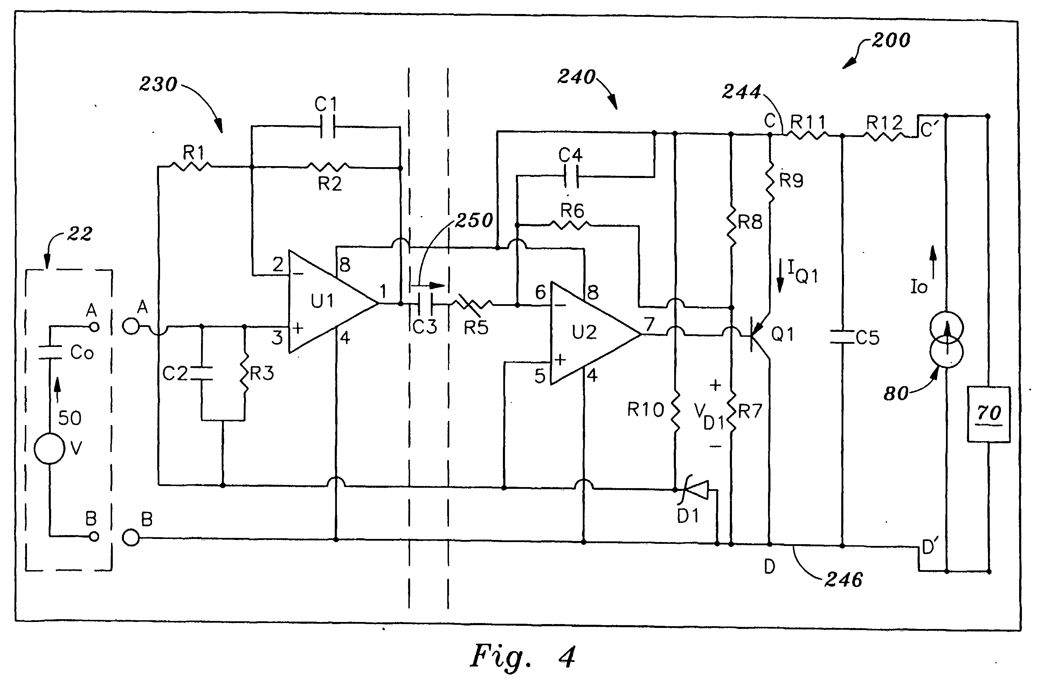

U.S. Patent No. 4,727,752 to Peters discloses an oscillator drive system for a piezoelectric crystal 20 whose output corresponds to a nearly sinusoidal resonator 12 signal and is illustrated as being used in an accelerometer. Peters discloses the application of driving the crystal with a digital signal where the oscillator is shown fig. 4. Alternative embodiments are disclosed.

U.S. Patent No. 4,807,482 to Park et al. discloses a method for measuring stimuli applied to a piezoelectric transmitter. Two embodiments are disclosed.

U.S. Patent No. 5,097,223 to Alexander teaches the use of a current feedback audio power amplifier utilizing a pair of op-amps A1 and A2 wherein A1 is a buffer amplifier used for audio gain and A2 is used for sub-audio gain. The output of A1 is connected in a voltage gain feedback circuit back to its inverting input and a voltage gain feedback loop is connected across A2. A current limiting circuit can be provided if desired to limit the current in the output stage.

U.S Patent No. 5,130,598 to Verheyen et al. discloses apparatus for driving a piezoelectric actuator for a fuel injector.

U.S. Patent No 4,885,707 to Nichol et al. discloses a vibration monitor with a sensor, a constant power signal conditioning circuit, an integrating amplifier, and an active high gain op-amp and buffer circuit.

U.S. Patent No 4,843,344 to Cox discloses a high voltage amplifier including a constant current powered signal conditioning circuit and an op-amp.

U.S. Patent No 3,860,481 discloses a metal impact monitor including sensor means generating an acceleration signal, a conditioning circuit with an integrator circuit and an op-amp.

OTHER PRIOR ART

Industrial Monitoring Instrumentation a division of PCB Piezotronics Inc.;
Machinery Vibration Measurement & Monitoring Instrumentation; 1992.
Columbia Research Labs, Inc. a Piezoelectric Products Division; 1985.
Imo Industries Inc., CEC Instruments Division, Pressure and motion transducers for high performance industrial and mil/aerospace applications, Short form catalog Kistler Instrument Corp., Measure Acceleration, Shock and Vibration.
Metrix Instrument Co.,1991/1992 Catalog. Pages 6-9,14-23.
PCB Piezotronics Inc. Low impedance quartz accelerometers series 300.
SKF, Condition Monitoring Catalog, 1991, pages B-38 to B-45.
Vibra•Metrics, Accelerometer Selector guide, September 1, 1989 bulletin VM142.
Vibro-Meter Corp., 400 Series Charge-Coupled Accelerometers, pages 2-1-7.
Wilcoxon Research, Industrial Vibration Sensors.
Wilcoxon Research, Short form Catalog of Vibration Instrumentation, March 1991, pages 1-12.

The other prior art listed above, but not specifically discussed, further chronicle the prior art of which the applicant is aware.

**Disclosure of Invention**

The present invention comprises a two-wire transducer for measuring machine vibration. This vibration is received by an sensor which includes a piezoelectric crystal for transforming the received acceleration signal into a signal whose frequency is equal to the frequency of vibration and whose amplitude is proportional to the acceleration of vibration. The transformed signal is received by and integrated into a velocity signal by a first stage of a two stage circuit contained in a constant current powered signal conditioning circuit.

The sensor, in combination with the first stage, operate at a bias above circuit ground. This elevated bias is the result of a constant current source biasing a zener diode to provide a constant reference voltage.

The second stage comprises a second op-amp configured as a high gair amplifier with a means for calibration of the overall sensitivity of the transducer The output of the second op-amp is directly coupled to a base of a PNP transisto which is configured as an emitter follower and functions as a signal output drive and a current compensator.

The velocity signal output of the first stage referenced to the elevated bias is capacitively coupled, to eliminate the DC component passed by the first stage, to the second stage amplifier wherein the second stage amplifies and outputs a voltage signal in accordance with the velocity signal input.

The constant current powered signal conditioning circuit further provides a stable DC voltage biasing of the output signal, the constant current source and the power terminals of the op-amps.

More specifically the invention is directed to a circuit, embodying the above second stage, for processing a vibration signal in a vibration monitoring device comprising in combination:

    a power source providing a constant current;
    a plurality of transmission lines having first ends and second ends;
    said first ends of said transmission lines operatively coupled to said constant current power source;
    a transistor operatively coupled to said second ends of said transmission lines;
    a feedback op-amp having an inverting input terminal, a noninverting input terminal , an output terminal and power supply bias terminals;
    said output terminal of said feedback op-amp operatively coupled to said transistor;
    a feedback loop from said output terminal of said feedback op-amp , through said transistor and to one of said input terminals of said feedback op-amp;
    and said one of said input terminals of said feedback op-amp receiving the vibration signal.

According to the invention, the conditioned output signal from said output terminal of said feedback op-amp drives and causes an impedance change of said transistor wherein said impedance change along with an amount of said constant current through said transistor provide said conditioned output signal to said second ends of said transmission lines and wherein said feedback loop returns a portion of said conditioned output signal back to said one of said input terminals of said feedback op-amp and is merged with the vibration signal such that said conditioned output signal is indicative of the magnitude of vibration being monitored.

Other objects of the invention are defined in the annexed dependent claims.

## Brief Description of Drawings

Figure 1 is an elevational view of the transducer device of this invention in place on a machine for monitoring of the vibration thereof.

Figure 2 is a sectional view taken along line 1A-1A of figure 1 with portions of the machine and the transducer cut away to reveal interior details thereof.

Figure 3 is a schematic view of a circuit utilized for conditioning of a signal within the transducer.

Figure 4 is a schematic view of an alternative embodiment of that which is shown in figure 3.

Figure 5 is a schematic view of a second alternative embodimentof that which is shown in figure 3.

Figure 6 is a schematic view of a third alternative embodimentof that which is shown in figure 3.

## Best Mode(s) For Carrying Out The Invention

Before delineating the description of the operation of the two-wire constant current powered transducer some basic introductory material is provided to simplify the circuit description and analysis.

First, the variable and double-subscript notation that is utilized in the voltage description of an AC signal, a DC signal and the combination of the two is as follows: AC signals use lower case letters for the variable and double-subscript notation (e.g. $v_{cd}$), DC signals use upper case letters for the variable and double-subscript notation (e.g. $V_{CD}$) and the superimposed AC and DC signals use lower case letters for the variable and upper case letters for the double-subscript notation (e.g. $v_{CD}$).

Second, note that "operational amplifier" (abbreviated op-amp) refers to a direct-coupled high gain amplifier to which feedback is added to control its overall response characteristic. A typical op-amp has five basic terminals: two for supply power, two for input signals (which are labeled with a negative (-) sign and positive (+) sign), and one for the output. The input terminal marked with a negative sign is referred to as the inverting input because it produces an output signal that is inverted or 180 degrees out of phase with the input signal. The input terminal marked with a positive sign is referred to as the noninverting input because it produces an output that is not inverted or "phase preserved". As an aid in circuit analysis, the "ideal" characteristics of an op-amp are used. This is practical because the "ideal" characteristics of the op-amp closely approximate that of real op-amp characteristics. A summary of the ideal characteristics of the op-amp that are applied for simplification of circuit analysis are as follows:

1. The input impedance of the inverting and noninverting terminals is infinitely large; thus, the input current to the op-amp is zero.

2. The voltage ($v_{+-}$) between the inverting and noninverting terminals is zero. This is described by saying that the input terminals "stick" together.

3. The open loop voltage gain is infinite.

4. Output impedance is zero; consequently, output voltage is independent of load.

5. The bandwidth is infinite.

6. The op-amp characteristics do not drift with temperature.

These and other characteristics of the op-amp can be found in MicroElectronics Digital and Analog Circuits and Systems by Jacob Millman, McGraw-Hill Book Company, 1979 at pages 523 through 525.

In conclusion of the basic introductory material it should be noted that in critical applications of low-level inputs and high gain, the power supply requirements are extremely stringent. Voltage changes or noise on the power-supply lines can be coupled into an op-amp and appear as equivalent input signals. Manufacturers take this into account in the design of op-amps by minimizing these effects. The ability of an op-amp to reject voltage changes or power-supply-induced noise and drift on the power supply lines is called the power-supply rejection ratio (PSRR). Stated another way, the (PSRR) is the ratio of the change in input offset voltage to the change in power-supply voltage producing it. Ratings may be given for each power supply separately or together, giving a typical value and a maximum limit. The unit of measure may be $\mu V/V$ or decibels (dB).

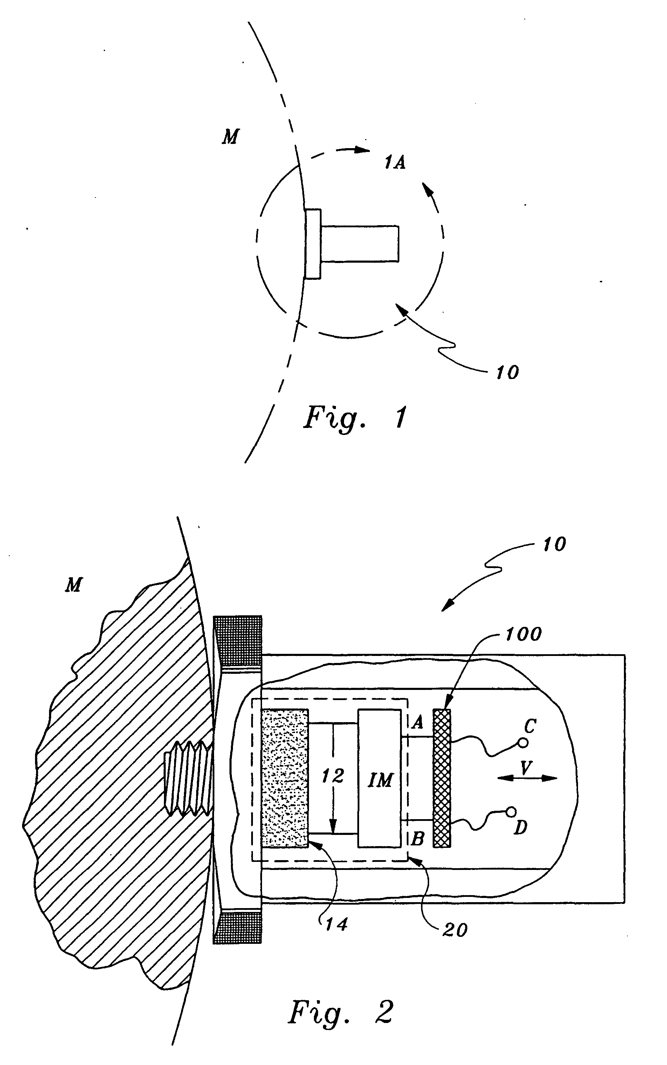

Referring to the drawings, figure 1 shows an elevational view of the two-wire constant current powered transducer 10 coupled to a vibrating machine M for monitoring the acceleration of vibration thereof.

Referring to figure 2, reveals a sectional view of the two-wire constant current powered transducer 10 for monitoring acceleration of vibration and for outputting an acceleration signal of amplitude proportional thereto. The two-wire constant current powered transducer 10 utilizes a piezoelectric crystal 12 situated between an sensor base 14 and an inertial reference mass IM as a sensor 20 of acceleration. When the two-wire constant current powered transducer 10 is coupled to the machine M, the vibration of machine M causes a compression or tension force "V" to act on the piezoelectric crystal 12. The piezoelectric crystal 12, in turn, acts as a precision spring to oppose compression or tension force thereby generating an electric charge. Thus, an output directly proportional to amplitude of acceleration is produced at terminals A and B of the sensor 20.

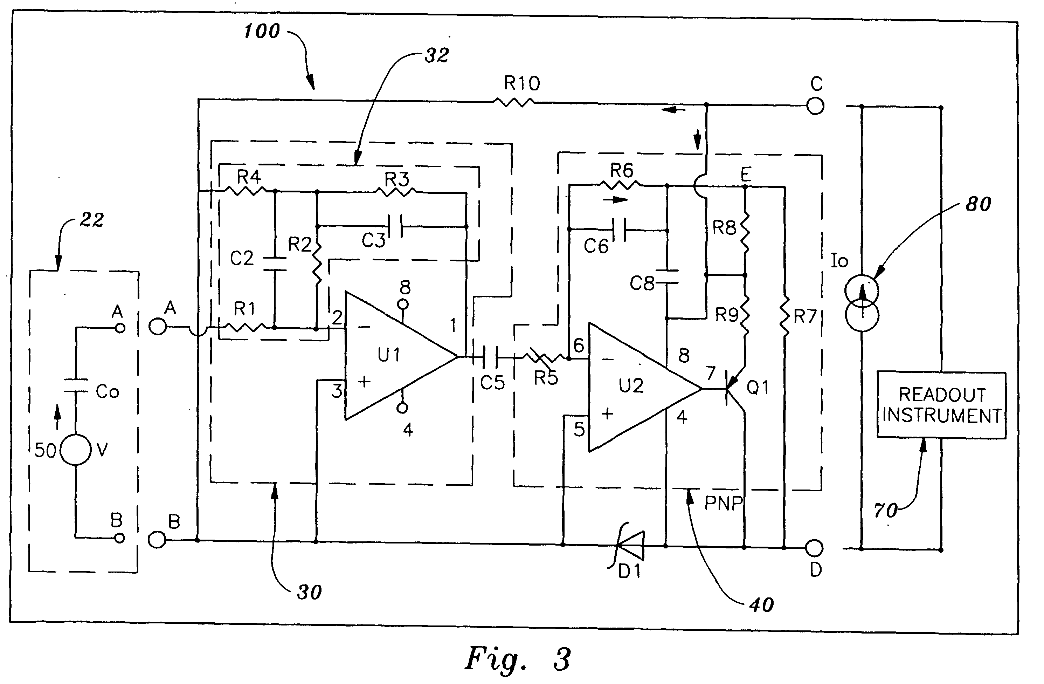

Figure 3 illustrates the equivalent circuit 22 of the sensor 20 (shown in figure 2). The output terminals A and B of the equivalent circuit 22 are the same terminals A and B of the sensor 20 (shown in figure 2). These terminals are coupled to nodes A and B of the constant current powered signal conditioning (CCPSC) circuit 100 which includes a first stage 30 and a second stage 40.

The equivalent circuit 22 can be treated as a voltage source whose input signal 50 (i.e. to the CCPSC circuit 100) has a frequency equal to the vibration frequency of the machine M and whose amplitude is proportional to the magnitude of acceleration. This voltage source is in series with an equivalent capacitor CO. The capacitance is determined by the effective area of the parallel plated conductive material (usually metal) on the piezoelectric crystal 12 (figure 2) and the dielectric constant of the piezoelectric crystal 12 (figure 2). This equivalent circuit 22 is used in the design of the first stage 30.

The acceleration signal 50 is received by op-amp $U_1$ through the equivalent crystal capacitor $C_0$ and input resistor $R_1$. Resistor $R_1$ determines the input impedance of the constant current powered signal conditioning (CCPSC) circuit 100. This RC network ($R_1$ and $C_0$) acts as a high pass filter (typically -3db around 10 to 20 Hz for the reference values listed below). To make a low frequency velocity transducer, this invention applies compensation.

Figure 3 further illustrates the constant current powered signal conditioning (CCPSC) circuit 100 connected to the equivalent circuit 22 (sensor 20 of figure 2) for converting the acceleration signal 50 into an output voltage signal indicative of a magnitude of vibration.

The first stage 30 of the constant current powered signal conditioning (CCPSC) circuit 100 is an active integrating amplifier (AIA) circuit 30. The AIA circuit 30 integrates the acceleration signal 50 by utilizing network (32) which includes capacitors $C_2$, $C_3$ and resistors $R_1$, $R_2$, $R_3$ and $R_4$ configured to a first op-amp $U_1$. Using the resistor and capacitor network 32 allows relatively small resistor values so that the disadvantages of large value resistors can be avoided.

The first op-amp $U_1$ has a noninverting input pin 3 connected to a first terminal B of the equivalent circuit 22, an inverting input pin 2 connected to a second terminal A of the equivalent circuit 22 through a resistance $R_1$, an output at pin 1 capacitively coupled to the second stage 40 of the CCPSC circuit 100, and a feedback loop including a capacitance (capacitors $C_2$ and $C_3$) coupled between the inverting input pin 2 and the output pin 1 of the first op-amp $U_1$.

A T-network results when resistor $R_1$ is excluded from network 32. The T-network includes a top branch having two portions and a base branch. The base branch includes impedance means ($R_2$ in parallel with $C_2$) having one end coupled to the inverting input pin 2 of the first op-amp $U_1$ and another end coupled to the intersection of the two portions of the top branch. The top branch includes resistive means ($R_4$) on one portion which is connected to the noninverting input pin 3 and an impedance means ($R_3$ in parallel with $C_3$) on another portion which is connected to the output terminal pin 1 of the first op-amp $U_1$.

The frequency at which the gain of the first stage 30 has a value of one is determined by the resistor and capacitor network 32.

The first stage 30 has a gain, $Gain_1$, that varies with the vibration frequency of the machine M. A simple calculation reveals the mid-band gain-frequency response:

$$Gain_1(f) = (1/R_1 C_2 + 1/R_1 C_3)/(2\pi f)$$

Which can be simplified as:

$$Gain_1(f) = 1/(2\pi f C_{23} R_1)$$

Where $C_{23}$ is the serial capacitance of $C_2$ and $C_3$;
Where f = frequency in Hertz; and
Where $\pi$ = the constant Pi 3.14...

The low frequency response of the integrated signal is determined by the equivalent piezoelectric crystal capacitance $C_0$ and the input impedance $R_1$ of the constant current powered signal conditioning (CCPSC) circuit 100.

The second stage 40 of the constant current powered signal conditioning (CCPSC) circuit 100 is capacitively coupled to the active integrating amplifier (AIA) circuit 30 (i.e. the first stage 30) for supplying a voltage output in accordance with the velocity voltage signal, whereby the output voltage is correlative of the vibration being monitored. The output of op-amp $U_2$ is directly coupled to a PNP transistor Q1.

Transistor $Q_1$ is configured as a common-collector (CC) transistor amplifier. This configuration is also called an "emitter follower", because its voltage gain is close to unity, and hence a change in base voltage appears as an equal change across the load at the emitter. In other words, the emitter follows the input signal. It can be shown that the input resistance of an emitter follower is very high (on the order of hundreds of Kilohms) and the output resistance is very low (on the order of tens of ohms). Hence, the most common use for the CC transistor circuit is as a buffer stage which performs the function of resistance transformation (from high to low resistance) over a wide range of frequencies, with voltage gain close to unity. In addition, the emitter follower increases the power level of the signal.

$Q_1$ functions as a signal output driver (buffer) and a current compensator. The current $I_{Q1}$ is determined by the constant current $I_O$, the power consumption of $U_1$ and $U_2$, the current flow through the zener diode $D_1$, $I_{D1}$ and the current losses, $I_{loss}$ (through $R_8$, $R_4$ and $R_2$, $R_3$, $R_4$) which are relatively small.

$$I_{Q1} = I_{CD} - I_{D1} - I_{U1} - I_{U2} - I_{loss}$$

The impedance change of $Q_1$ multiplied by the transistor current $I_{Q1}$ is the output signal voltage $v_{cd}$ which overlaps onto the DC bias voltage $V_{CD}$. This output will be controlled by the second stage 40 which acts as a gain stage and a frequency compensator by trading off high gain of the op-amp $U_2$ for a larger bandwidth.

The change of the output voltage of op-amp $U_2$ is equal to the AC output voltage together with a very small variation due to the change in the voltage between the emitter and base of transistor $Q_1$ caused by the AC current, temperature, and the variation between different devices. This variation is compensated by the large gain of op-amp $U_2$. The total frequency response will not be influenced by the characteristics of the transistor $Q_1$. To find the mid-band gain of the second stage 40, an AC analysis of the constant current powered signal conditioning (CCPSC) circuit 100 is done. The inverting input pin 6 is "AC ground" (all the voltages are referenced to node D) The input voltage $v_{in}$ through capacitor $C_5$ and resistor $R_5$ will generate a current $I_{in}$ calculated by the equation:

$$I_{in} = v_{in}/R_5$$

Since the input impedance of $U_2$ is extremely high, very little current flows into op-amp $U_2$ pin 6 and virtually all the input signal current will flow to node E causing a change in the voltage at node E. $v_e$ is calculated by the equation:

$$v_e = -I_{in} R_6 = -v_{in} R_6/R_5$$

This voltage will generate a current through resistor $R_7$ calculated by:

$$I_7 = v_e/R_7$$

The potential difference between node C and E will also generate a current through $R_8$ to node E calculated by:

$$I_8 = (v_c - v_e)/R_8$$

At node E, summing currents by the equation:

$$I_{in} + I_8 = I_7$$

establishes the value of $I_7$.

From the above equations, the mid-band voltage gain of the second stage 40 is derived. It is expressed as:

$$Gain_2 = v_{cd}/v_{in} = (R_7 R_8 + R_6 R_7 + R_6 R_8)/(R_5 R_7)$$

The total mid-band frequency response of constant current powered signal conditioning (CCPSC) circuit 100 from node A, B to C, D is the multiple of $\text{Gain}_1$ and $\text{Gain}_2$.

The above mid-band voltage gain equations of the constant current powered signal conditioning (CCPSC) circuit 100 reveals the characteristic of an output signal being independent of any active elements and dependent only on the passive components therein.

Regarding the mid-band, the output at pin 1 of the first stage 30 will have a phase shift of 90° referenced to the input, the second stage 40 will add an additional phase shift of 180°. Therefore, the overall phase shift will be 90° which is equal to the phase difference of velocity and acceleration. The high and low end phase shift will be determined by the poles and zeros of the constant current powered signal conditioning (CCPSC) circuit 100 which can be derived using transform methods common in the art.

Together, resistor $R_6$ and the optional capacitor $C_6$ will determine the high end of the frequency response. The capacitor $C_6$ is used to compensate for stray input capacitance between the inverting input at pin 6 of op-amp $U_2$ and AC ground and also between the noninverting input at pin 5 of op-amp $U_2$ and AC ground. The capacitor $C_6$ also compensates for any differential stray capacitance between the inputs of op-amp $U_2$.

Referring to figure 3, the DC voltage bias analysis of the constant current powered signal conditioning (CCPSC) circuit 100 comprising of a first stage 30 and the second stage 40 will be described. The constant current source 80 is conductively coupled for providing the current in the branch consisting of a serially connected resistor $R_{10}$ and zener diode $D_1$. This constant current source 80 provides the zener diode $D_1$ with a voltage at which the zener diode begins to operate in the breakdown region which is the criteria for the zener diode $D_1$ to operate as a voltage regulator thereby providing a highly stable reference voltage that is to be maintained across the diode. This regulated DC bias voltage is received by the input signal 50, the noninverting input at pin 3 of op-amp $U_1$ and the noninverting input at pin 5 of op-amp $U_2$. This voltage is higher than the reference potential of node D (circuit ground) by an amount equal to $V_{BD}$.

The output from the first stage 30 is the output from pin 1 of op-amp $U_1$. The DC output level of the first stage 30 (pin 1 of op-amp $U_1$) referenced to node D is equal to the voltage drop across the zener diode $D_1$. The output from the first stage 30 pin 1 referenced to node B is independent of any variation of the zener diode $D_1$. This output is capacitively coupled via capacitor $C_5$ to the input of the second stage 40. This in turn is coupled via potentiometer $R_5$ to the inverting input pin 6 of op-amp $U_2$. Potentiometer $R_5$ calibrates the overall sensitivity of the transducer 10 to compensate for the sensitivity variation of the sensor 20 (shown in figure 2).

The DC bias voltage applied to the noninverting input at pin 5 of op-amp $U_2$ will appear at the inverting input pin 6 of op-amp $U_2$ due to the ideal characteristics described previously. Also, the ideal characteristics indicate that the op-amp $U_2$ has no current flow into or out of the noninverting pin 5 and inverting pin 6 terminals. One result of the ideal characteristics is that the voltage regulator (zener diode $D_1$) remains unloaded (load current is not drawn from the branch containing resistor $R_{10}$ and zener diode $D_1$).

The capacitors ($C_5$, $C_6$, and $C_8$) also prevent DC current flow in their respective branches. As a result, no DC current passes through resistor $R_6$. $V_{D1}$, the DC drop across the zener diode $D_1$, and resistors $R_7$, $R_8$ alone will determine the output DC bias voltage $V_{CD}$. Since op-amp $U_2$ has high gain (which is described above) it causes transistor $Q_1$ to draw just enough current from the constant current source 80 to force output $V_{CD}$ to a voltage that will maintain the voltage across $R_7$ equal to $V_{D1}$. This must occur because the voltage across resistor $R_6$ caused by the input leakage current of op-amp $U_2$ is negligible. Resistors $R_8$ and $R_7$ form a voltage divider network for the output voltage $V_{CD}$ having a value defined by:

$$V_{CD} = V_{D1}(R_7 + R_8)/R_7$$

This equation can also be derived by noting that the current $V_{D1}/R_7$ is flowing in resistor $R_7$ and that same current must flow through resistor $R_8$ (since no DC current passes through $R_6$ due to the ideal characteristics discussed above). Thus, a DC output voltage $V_{CD}$ can be calculated from:

$$V_{CD} = (V_{D1}/R_7) (R_7 + R_8)$$

From the above equation, it is noted that the output DC bias is independent of "active" device parameters such as the PNP transistor $Q_1$. It is only determined by the passive elements (i.e. resistors) that are fairly stable throughout the range of operation in the environment. This feature provides distinct advantages of this invention over the prior art, especially by applying op-amps.

Voltage $V_{CD}$ provides the DC bias voltage of the positive power supply terminal pin 8 and the negative supply terminal pin 4 which are shared by both op-amps $U_1$ and $U_2$. This DC voltage also provides the biasing of the constant current source 80. By using this "pre biased" technique, any noise of the first stage 30 created by ground loops and bias fluctuations of zener diode $D_1$ will be greatly reduced, greatly enhancing the transducer 10 performance.

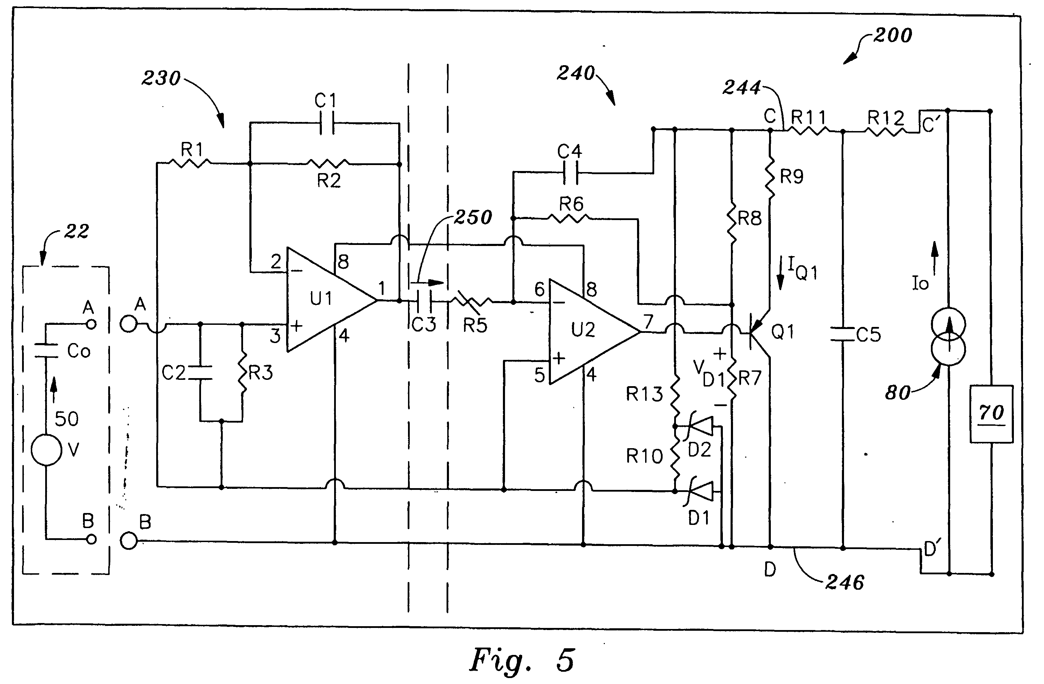

Figures 4 and 5 show circuit schematics of alternative embodiments of the constant current powered signal conditioning (CCPSC) circuit 100 shown in figure 3. Note that the circuits shown in figures 4 and 5 share the same unique features as discussed supra with respect to the CCPSC circuit 100 shown in figure 3.

In essence, and referring to figure 4, input terminals A, B of a gain stage 230 receives an input signal 50 from a sensor 20 (figure 2). This input signal 50 is then amplified by the gain stage 230 and outputted to an input of a second stage 240 via capacitor $C_3$.

This amplified signal 250 is received and integrated by the second stage 240 and then outputted, by way of a transistor $Q_1$, onto the same plurality of transmission lines 244, 246 providing the constant current to the CCPSC circuit 200. The transmisison lines have first ends operatively coupled to the constant current power source 80 and second ends operatively coupled to terminals C and D.

The constant current source 80 provides a current to a first branch including a first resistance means, resistor $R_{10}$, connected in series with the first zener diode $D_1$ in the CCPSC circuit 200. This causes the zener diode $D_1$ to operate as a voltage regulator thereby providing a highly stable DC reference voltage $V_{D1}$ that is maintained across the diode $D_1$. This regulated DC reference voltage $V_{D1}$ is used to bias, above circuit ground, the input signal 50 and the amplified signal 250 to the gain stage 230 and the second stage 240, respectively. In addition, the regulated DC reference voltage $V_{D1}$ works in cooperation with the second stage 240 to provide a stable DC voltage biasing of an output voltage signal vcd and the power supply bias terminals pin 4 and pin 8 which are shared by both $U_1$ (gain stage op-amp) and $U_2$ (feedback op-amp).

More specifically, the input of the gain stage 230 receives the input signal 50 from the sensor 20 which, as mentioned, utilizes a piezoelectric crystal 12 situated between a sensor base 14 and an inertial reference mass IM as a sensor 20 of acceleration (figure 2). When the sensor 20 is coupled to a source of vibration to be monitored, the vibration of the source causes a compression or tension force to act on the piezoelectric crystal 12. The piezoelectric crystal 12, in turn, acts as a precision spring to oppose compression or tension forces thereby generating an electric charge. Thus, a signal directly proportional to the amplitude of acceleration of the source of vibration is produced at output terminals A and B of the sensor 20.

Referring to figure 4, the sensor 20 is modeled by the equivalent circuit 22 which includes a voltage source whose input signal 50 has a frequency equal to the vibration frequency of the source of vibration and whose amplitude is proportional to the magnitude of acceleration of the source of vibration. This voltage source is coupled in series with an equivalent capacitor $C_0$. Output terminals A and B of the equivalent circuit 22 of the sensor 20 are operatively coupled to nodes A and B and respectfully to the noninverting and inverting inputs of op-amp $U_1$ of the gain stage 230. The gain stage circuit 230 amplifies the input signal 50 received from the equivalent circuit 22 by using an op-amp $U_1$ along with a number of associated components. The op-amp $U_1$ provides the necessary amplification and the associated components (capacitors $C_1$, $C_2$ and resistors $R_1$, $R_2$ and $R_3$) are used to control the operation of the op-amp $U_1$ and effectively regulate the overall characteristics as well as the stability of the gain stage circuit 230. A closed loop including a capacitance $C_1$ and a resistance $R_2$ are connected in parallel and coupled between the output terminal and the input terminal of the gain stage.

Gain equation 3 represents the gain of the gain stage circuit 230 without the impedance of the crystal:

$$\text{Gain}_3(f) = [1 + R_2/(R_1(1 + 2\pi f\, C_1\, R_2))]$$

Gain equation 4 represents the gain of the gain stage circuit 230 with the source impedance of the crystal included:

$$\text{Gain}_4(f) = [2\pi f\, C_0\, R_3/(1 + 2\pi f\, R_3(C_0 + C_2))]\,[1 + R_2/R_1(1 + 2\pi f\, C_1\, R_2)]$$

Note from the above equation that the crystal impedance will affect the frequency response of the gain stage 230.

The gain stage circuit 230 then passes the amplified signal 250 on to the second stage 240 via capacitor $C_3$. The amplified signal 250 is then received, integrated and outputted to terminals C and D by the second stage 240 of the CCPSC circuit 200.

Gain equation 5 represents an integrator response (i.e., low pass filter) of the second stage 240:

$$\text{Gain}_5(f) = -[R_6(R_7 + R_8)/(R_5\, R_7 + 2\pi f\, C_4\, R_5\, R_6(R_7 + R_8))]$$

The second stage uses adjustable resistance $R_5$ to couple the amplified signal 250 to an inverting input (pin 6) of a feedback op-amp $U_2$. The output of feedback op-amp $U_2$ is directly coupled to a PNP transistor $Q_1$. In addition, a feedback loop runs from the output terminal of the feedback op-amp $U_2$, through the transistor and to the inverting input terminal of the op-amp $U_2$. The transistor $Q_1$ is operatively coupled to the second ends of the transmission lines and functions as a signal output driver (buffer) which outputs an amplified and filtered velocity voltage signal $v_{cd}$ across terminals C and D. Moreover, the output of op-amp $U_2$ causes an impedance change of transistor $Q_1$ thereby causing a change of impedance between terminals C and D. This impedance change of $Q_1$ along with the transistor current $I_{Q1}$ results in a variable output voltage $v_{cd}$ across terminals C and D, whereby the output voltage $v_{cd}$ is correlative of the vibration being monitored.

In other words, a conditioned output signal from the output terminal, pin 7 of op-amp $U_2$, of the feedback op-amp $U_2$ drives and causes an impedance-change of the transistor $Q_1$ wherein the impedance change along with an amount of the constant current through the transistor $Q_1$ provide the conditioned output signal $v_{cd}$ to the second ends of the transmission lines 244, 246 and wherein the feedback loop returns a portion of the conditioned output signal back to the inverting input terminal of the feedback op-amp $U_2$ and is merged with the vibration signal 250 such that the conditioned output signal $v_{cd}$ is indicative of the magnitude of vibration being monitored.

The zener diode $D_1$ is biased to operate as a stable DC voltage regulator providing a stable DC reference voltage $V_{D1}$, above circuit ground. This biasing is accomplished by the constant current source 80 providing a current in a branch consisting of a serially connected resistor $R_{10}$ and the zener diode $D_1$.

The zener diode $D_1$ provides the stable DC reference voltage $V_{D1}$ to the input signal 50 that is received by the gain stage 230 of the CCPSC circuit 200. In addition, the stable DC voltage $V_{D1}$ is also applied to the noninverting input at pin 5 of the op-amp $U_2$. This voltage $V_{D1}$ will appear at the inverting input pin 6 of op-amp $U_2$ due to the ideal characteristics of the op-amp $U_2$. Also, the ideal characteristics dictate that the op-amp $U_2$ has no current flow into or out of the noninverting pin 5 and inverting pin 6 terminals. The capacitors $C_3$ and $C_4$ also disallow DC current flow in their respective branches. As a result, no DC current passes through resistor $R_6$. Therefore, the stable DC voltage $V_{D1}$ appearing at the inverting input pin 6 and at an end of resistor $R_6$ coupled thereto will appear at the opposite end of resistor $R_6$ without a voltage drop occurring across resistor $R_6$ thereby providing a regulated voltage $V_{D1}$ across $R_7$. Note that the current through $R_7$ is provided by the constant current source and not by the regulated voltage $V_{D1}$ itself, thereby providing an unloaded voltage $V_{D1}$ across $R_7$.

The resistor $R_7$ is contained in a branch of two serially connected resistors, $R_7$ and $R_8$, having one end connected to terminal C and the second end connected to terminal D. The regulated voltage across $R_7$ draws a constant current through both $R_7$ and $R_8$. This sets up a stable DC voltage across terminals C and D which is used to provide a stable DC bias voltage of the output signal $v_{cd}$ and the power supply bias terminals pin 4 and pin 8 shared by both op-amps $U_1$ and $U_2$.

As a result of having the transmission lines 244, 246 double as the signal output lines the op-amps must be able to reject the output signal $v_{cd}$ from interfering with the operating characteristics of the op-amps $U_1$ and $U_2$. The ability of the op-amps $U_1$ and $U_2$ to reject signals on the transmission lines 244, 246 from interfering with the operating characteristics of the op-amps $U_1$ and $U_2$ is referred to as the power supply rejection ratio (PSRR).

Figure 5 is a circuit schematic of that which is shown in figure 4 with at least one notable exception, i.e., a second zener diode $D_2$ is used to provide the stable DC voltage biasing of the power supply bias terminals pin 4 and pin 8 shared by both op-amp $U_1$ and $U_2$. This change may be incorporated in applications where it is found that the superposition of the output signal 252 on top of the power supply signal is affecting the characteristics of the circuit 200.

Note also that in figure 5 the connection between the positive power supply terminal, pin 8, of the op-amps $U_1$ and $U_2$ and terminal C is removed. Therefore, the output voltage signal $v_{cd}$ at terminals C and D is not superimposed on top of the power supply signal biasing the op-amps $U_1$ and $U_2$. Instead, the positive power supply bias terminal, pin 8, of the op amps $U_1$ and $U_2$ is connected to a cathode of a zener diode $D_2$. An anode of the zener diode $D_2$ is connected to the negative power supply bias terminal, pin 4, of the op-amps $U_1$ and $U_2$.

Therefore, when the constant current source provides a current to zener diode $D_2$ via a resistor $R_{13}$ the diode $D_2$ operates as a stable DC voltage regulator which provides the DC voltage biasing of the power terminals, pin 8 and pin 4, of the op-amps $U_1$ and $U_2$.

Referring to figures 4 and 5, the T-network 242 is used to couple terminals C and D to terminals C' and D' respectively. The T-network 242 includes a top branch having two portions and a base branch. The base branch includes capacitor $C_5$ having one end coupled to terminals D and D' and another end coupled to the intersection of the two portions of the top branch. The top branch includes resistor $R_{11}$ on one portion which is connected to terminal C and resistor $R_{12}$ on another portion which is connected to terminal C'. The purpose of the T-network 242 is to filter out any induced line transients on the lines connecting the constant current source 80 and the readout instruments 70 to the CCPSC circuit 200.

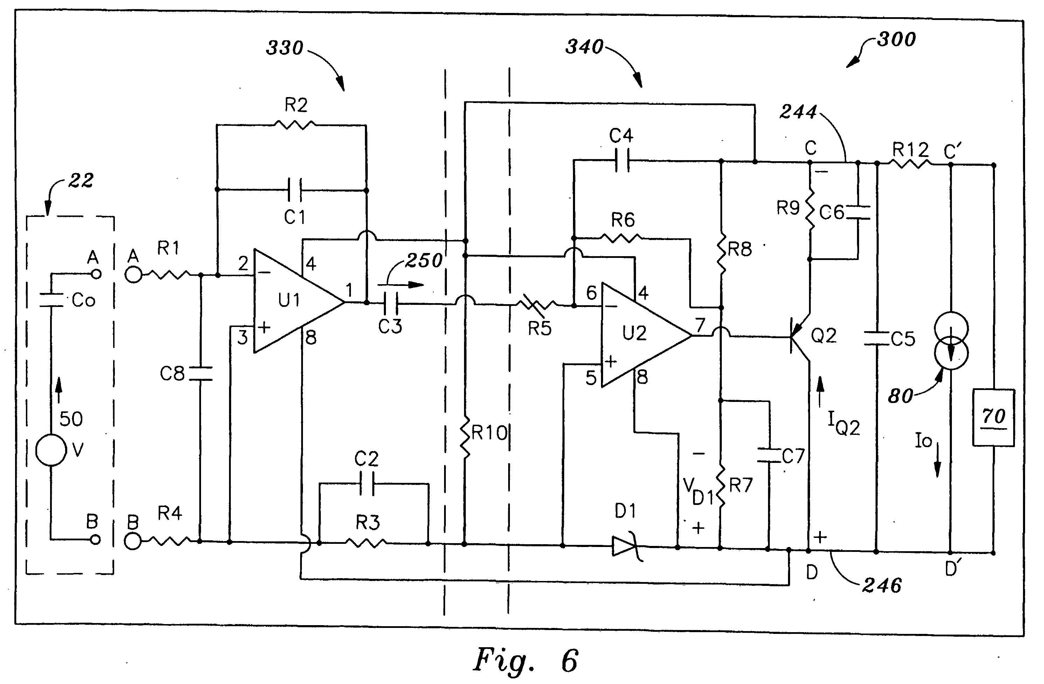

Figure 6 is a circuit schematic of an alternative embodiment of the constant powered signal conditioning (CCPSC) circuit 100 shown in figure 3. The circuit shown in figure 6 shares the same unique features as discussed supra with respect to the CCPSC circuit shown in figures 3 through 5.

The discussion of the second stage 340 shown in figure 6 follows the above discussion with respect to the second stage 240 shown in figure 4. However, there is at least one notable exception, i.e., the current $I_0$ which powers the CCPSC circuit 300 flows in an opposite direction through the circuit 300 as compared with that which is shown in figures 3, 4 and 5. To accomplish this the transistor $Q_1$ in figure 4 is changed from a PNP transistor $Q_1$ to an NPN transistor $Q_2$. In addition, the connections to the power supply bias terminals, pin 8 and pin 4, are swapped and the zener diode is turned around.

Figure 6 shows a charge coupled differential CCD amplifier stage 330 interposed between and operatively coupled to the sensor 20 (equivalent circuit 22) and to the feedback op-amp $U_2$. Input terminals A, B of the charge coupled differential amplifier stage 330 receive the vibration signal 50, i.e., the acceleration signal from the sensor 20, in terms of coulombs (charge). The CCD amplifier stage 330 converts the vibration signal 50 in terms of coulombs into a vibration signal 250 in terms of volts. The CCD amplifier stage 330 is able to make this conversion by implementing the equation V=Q/C where Q is charge, V is voltage and C is capacitance. The charge produced by the motion of the piezoelectric crystal 12 is applied to $C_1$ and $C_2$ (figure 6), this in turn produces a voltage, according to the equation V=Q/C at the output, pin 1, of a CCD op-amp $U_1$. A discussion of the connection between the output, pin 1, of the CCD op-amp $U_1$ and the feedback op-amp $U_2$ shown in figure 6 follows the above discussion with respect to the connection between the op-amps $U_1$ and $U_2$ shown in figures 3, 4 and 5. One advantage of using the CCD amplifier stage 330 is that the sensor 20 can be remotely located from the CCD op-amp $U_1$.

The charge coupled differential amplifier stage 330 is used to help reduce common mode noise. However, a single ended charge coupled (CC) amplifier stage could also accomplish the same conversion, changing the vibration signal 50 in terms of charge into a vibration signal 250 in terms of volts. This single ended charge conversion can be created by simply shorting out $C_2$ and $R_3$ in the CCD amplifier stage 330.

To recap, one hallmark of figures 3, 4, 5 and 6 resides in feedback op-amp $U_2$ receiving an input signal generated from a sensor and outputting an output signal which causes an impedance change of the transistor. This impedance change along with an amount of the constant current through the transistor provide the conditioned output signal $v_{cd}$ across terminals C and D. In addition, a further attribute is that zener diode $D_1$ provides a DC reference voltage $V_{D1}$ which works in cooperation with the feedback op-amp $U_2$ in order to provide stable DC voltage biasing across terminals C and D.

In use and operation, and referring to figure 3, the constant current powered signal conditioning (CCPSC) circuit 100 consists of a single monolithic chip with dual op-amps $U_1$ and $U_2$ therein and supporting hardware to perform the function of signal processing an input acceleration voltage signal (across terminals A,B) to an output voltage signal (across terminals C,D) for utilization by a readout instrument 70 connected thereto. Power for the constant current powered signal conditioning (CCPSC) circuit 100 is provided by a constant current source 80 outputting a constant current $I_O$.

A dual conductor transmission line (i.e. coaxial cable or a simple twisted pair) is not only used to monitor the output signal but is also used to provide the signal conditioning circuit 100 with operating power. Because the power supply leads double as the signal output leads two or three extra wires are eliminated in remote signal applications.

The constant current powered signal conditioning (CCPSC) circuit 100 integrates and amplifies the signal 50 by passing the signal 50 through two stages 30, 40. The first stage 30, an active integrator amplifier (AIA) circuit, integrates the input signal 50 via op-amp $U_1$ and circuitry configured thereto and outputs a voltage velocity signal which is capacitively coupled by capacitor $C_5$ to the second stage 40, which includes a high gain op-amp $U_2$ having its output directly coupled to the base of transistor $Q_1$ wherein $Q_1$ functions as a signal output driver (buffer) and a current compensator. The output of op-amp $U_2$ causes an impedance change of transistor $Q_1$. This impedance change of $Q_1$ is multiplied by the transistor current $I_{Q1}$ to provide the output signal voltage $v_{cd}$, that corresponds to the vibration of the machine M, which overlaps onto the DC bias voltage $V_{CD}$ which is provided by the biasing technique that follows.

At the outset the constant current source 80 provides the signal conditioning circuit 100 with a constant current at an initial DC bias voltage of 24 volts. This provides the current flow in the branch containing resistor $R_{10}$ and a zener diode $D_1$. The zener diode $D_1$ is biased to function as a stable DC voltage regulator providing a stable DC reference voltage above circuit ground to the input signal 50, the noninverting input (pin 3) of op-amp $U_1$ and the noninverting input (pin 5) of op-amp $U_2$.

The ideal characteristics of op-amp $U_2$ provides the following effect: first, the DC regulated voltage that is provided at the noninverting input (pin 5) of op-amp $U_2$ will appear at the inverting input (pin 6) of op-amp $U_2$ and second, op-amp $U_2$ has no current flow into or out of the op-amp at both the noninverting (pin 5) and inverting (pin 6) terminals.

The capacitors $C_5$, $C_6$, and $C_8$ also prevent DC current flow in their respective branches. As a result, no DC current passes through resistor $R_6$ and the voltage appearing at the inverting input pin 6 and the first end of resistor $R_6$ will appear at the second end of resistor $R_6$ without a voltage drop occurring across resistor $R_6$ thereby providing a regulated voltage across $R_7$. The current through $R_7$ is provided by the constant current source 80 and not by the

voltage regulator $D_1$ itself thereby providing an unloaded voltage source across $R_7$.

The resistor $R_7$ is contained in a branch of two serially connected resistors, $R_7$ and $R_8$. This branch has a first end coupled to a first terminal C of the constant current source 80 and a second end coupled to the second terminal D (circuit ground) of the constant current source 80. The regulated voltage that is applied across resistor $R_7$ draws a constant current, from the constant current source 80, through said serially connected resistors, $R_7$ and $R_8$, and due to the high gain of op-amp $U_2$ the transistor $Q_1$ will provide a means to compensate for the remaining current that is provided by the constant current source 80. This unique biasing technique reduces the initial DC biasing voltage $V_{CD}$ from 24 volts to 12 volts.

Therefore, the signal conditioning circuit 100 has the ability to provide its own stable DC bias voltage in which active components and their fluctuations are eliminated. This stable DC bias voltage $V_{CD}$ is used for the biasing of the constant current source 80, the output signal and the power supply terminals pin 4 and pin 8 which are shared by both op-amps $U_1$ and $U_2$. This biasing technique is stable over a temperature range of -55°C to +125°C and for the life of the device.

The ability of an op-amp to reject signals on the power-supply line from interfering with the operating characteristics of the op-amp is referred to as the power-supply rejection ratio (PSRR). This characteristic allows the output signal to ride on top of the power supply signal without effecting the operating characteristics of the circuit.

Using the preferred components of the table below results in the conditioning circuit 100 having a 3db frequency response from approximately 2 Hz to 5 KHz over the stable bias temperature range of -55°C to +125°C.

Finally, it is noted that a very low AC impedance and a low temperature coefficient are required to maintain the stability of the circuit and frequency response. Judicious selection of op-amp $U_1$ is important to the performance of the transducer circuitry 100, because it will affect the noise, integration and large signal handling capacity of the circuit 100. In other words, op-amp $U_1$ should match the ideal characteristics as closely as possible.

Moreover, having thus described the invention, it should be apparent that numerous structural modifications and adaptations may be resorted to without departing from the scope and fair meaning of the instant invention as set forth hereinabove and as defined hereinbelow by the claims.

The following table summarizes the values of the components employed in a preferred embodiment of the invention:

| Element No. | Description | Value of Designation |
|---|---|---|
| R1 | Resistor | 20MΩ |
| R2 | Resis | 10MΩ |
| R3 | Resistor | 10MΩ |
| R4 | Resistor | 750KΩ |
| R5 | Resistor | 1.3MΩ |
| R6 | Resistor | 20MΩ |
| R7 | Resistor | 10MΩ |
| R8 | Resistor | 20MΩ |
| R9 | Resistor | 1KΩ |
| R10 | Resistor | 20KΩ |
| C2 | Capacitor | 0.01μF |
| C3 | Capacitor | 0.01μF |
| C5 | Capacitor | 0.1μF |
| C6 | Capacitor | 2PF |
| C8 | Capacitor | 0.01μF |
| U1 and U2 | Operational Amplifier | TL032 |
| D1 | Zener Diode | 4V |
| C0 | Piezo Crystal Capacitor | 800PF |
| Q1 | Transistor | PNP |

(continued)

| Element No. | Description | Value of Designation |
|---|---|---|
| I0 | Current Source | 3mA (typical) |

### Industrial Applicability

The industrial applicability of this invention shall be demonstrated through discussion of the following objects of the invention.

A primary object is to provide a device which does not require inordinate calibration because, *inter alia,* a majority of the components forming the circuit are passive elements, e.g. capacitors, resistors etc.

Another further object is to provide a reliable vibration sensor.

Another further object is to provide a vibration sensor which is stable both as a function of age and temperature change.

Another further object is to provide a vibration sensor which has an output DC bias independent of "active" device parameters.

Viewed from a first vantage point, it is an object of the present invention to provide a vibration monitor, comprising a sensor for monitoring vibration and for outputting an acceleration signal of amplitude proportional to the vibration and a constant-current, powered, signal conditioning (CCPSC) circuit connected to the sensor for converting the acceleration signal into an output voltage signal indicative of a magnitude of the vibration; the CCPSC circuit further including an active integrating amplifier (AIA) circuit having an input coupled to the sensor for integrating the acceleration signal into a velocity signal and an active high gain op-amp and buffer circuit coupled to the AIA circuit for supplying an output voltage in accordance with a voltage of the velocity signal; whereby the output voltage is indicative of the magnitude of vibration.

Viewed from a second vantage point, it is an object of the present invention to provide a vibration transducer including a sensor with a first voltage signal output representative of vibration input to the transducer, wherein the first voltage signal output correlative of an acceleration signal is received by a constant current powered signal conditioning circuit which comprises a first stage including a first op-amp to provide means for integrating the first voltage signal output and outputting a second voltage signal to a second stage including a second op-amp for inverting and amplifying the second voltage signal output and outputting a third signal representative of the vibration input wherein the conditioning circuit further comprises a regulated DC voltage reference and biasing means comprised of a first branch consisting of a serially connected first resistor and zener diode having a first end connected to a first terminal of the constant current source and and a second end connected to a second terminal of a constant current source by electrical connection means and the constant current source providing biasing means for the zener diode to function as a stable DC voltage regulator providing a regulated voltage; the first op-amp having inverting and noninverting inputs, power supply terminals and an output, the first stage including circuitry providing means for receiving the first voltage signal output and effectively integrating the acceleration signal and outputting the second voltage signal which is correlative of velocity, the second op-amp having inverting and noninverting inputs, power supply terminals and an output; and the inverting input of the second op-amp connected to the output of the first op-amp by means of a second branch, the second branch consisting of a serially connected capacitor and second resistor and the second stage providing means for inverting and amplifying the output of the first op-amp.

Viewed from a third vantage point, it is an object of the present invention to provide a method for conditioning an input signal by self-biasing a circuit having an op-amp which includes an inverting signal input terminal, a noninverting signal input terminal, bias voltage terminals and a signal output terminal, the steps including: providing a bias voltage for the op-amp through the bias voltage terminals, directing an input signal into the inverting terminal of the op-amp, outputting a conditioned signal from the output terminal, and combining the conditioned signal with the bias voltage; whereby performance of the amplifier is self-adjusted by characteristics of the conditioned signal such that the conditioned output signal rides on top of the bias voltage.

Viewed from a fourth vantage point, it is an object of the present invention to provide a constant-current, powered, signal conditioning circuit including an op-amp having an inverting input terminal and a noninverting input terminal, an output and power supply terminals, a transistor operatively coupled to the output of the op-amp and between the power supply terminals; a constant current power supply providing a power supply signal and operatively coupled to the power supply terminals of the op-amp via power supply lines for powering the op-amp; an input signal into the inverting terminal of the op-amp; an output signal from the op-amp driving the transistor; the transistor providing a signal to the power supply lines; and power supply rejection means integrally formed within the op-amp; whereby the output signal from the transistor rides on top of the power supply signal of the conditioning circuit.

Viewed from a fifth vantage point, it is an object of the present invention to provide a transducer for monitoring operating parameters, comprising in combination: a signal sensing and generating means, an integrator circuit having an inverting input coupled to the signal generating means, the integrator circuit providing an integrated signal output, an op-amp including an inverting input, an output and self bias means, the inverting input coupled to the integrated signal output of the integrator circuit, and the output of the op-amp fed back to the integrator circuit.

Viewed from a sixth vantage point, it is an object of the present invention to provide, in a vibration monitoring device, a sensor means for sensing and generating an acceleration signal corresponding to existing vibration from the source, and a signal conditioning circuit receiving the acceleration signal and including an integrator circuit providing means for integrating the first signal into a velocity signal correlative of the vibration being monitored; the signal conditioning circuit further comprising in combination: an op-amp including an inverting and noninverting input terminals, an output terminal and power supply terminals, the inverting input coupled to the output of the integrator circuit, and the output of the amplifier provides the second signal which is correlative of the vibration being monitored, and means for monitoring the second signal.

Viewed from a seventh vantage point, it is an object of the present invention to provide a circuit for processing a vibration signal in a vibration monitoring device comprising in combination: a power source providing a constant current; a plurality of transmission lines having first ends and second ends; the first ends of the transmission lines operatively coupled to the constant current power source; a transistor operatively coupled to the second ends of the transmission lines; a feedback op-amp having an inverting input terminal, a noninverting input terminal, an output terminal and power supply bias terminals; the output terminal of the feedback op-amp operatively coupled to the transistor; a feedback loop from the output terminal of the feedback op-amp, through the transistor and to one input terminal of the feedback op-amp; and the vibration signal into the one input terminal of the feedback op-amp; whereby a conditioned output signal from the output terminal of the feedback op-amp drives and causes an impedance change of the transistor wherein the impedance change along with an amount of the constant current through the transistor provide the conditioned output signal to the second ends of the transmission lines and wherein the feedback loop returns a portion of the conditioned output signal back to the one input terminal of the feedback op-amp and is merged with the vibration signal such that the conditioned output signal is indicative of the magnitude of vibration being monitored.

These and other objects will be made manifest when considering the following detailed specification when taken in conjunction with the appended drawing figures.

## Claims

**1.** A circuit (100) for processing a vibration signal (50) in a vibration monitoring device comprising in combination:

a power source (80) providing a constant current;
a plurality of transmission lines (244, 246) having first ends and second ends;
said first ends of said transmission lines operatively coupled to said constant current power source (80) ;
a transistor (Q1) operatively coupled to said second ends of said transmission lines;
a feedback op-amp (U2) having an inverting input terminal (6), a noninverting input terminal (5), an output terminal (7) and power supply bias terminals (4,8);
said output terminal of said feedback op-amp operatively coupled to said transistor;
a feedback loop from said output terminal (7) of said feedback op-amp (U2), through said transistor (Q1) and to one of said input terminals (6,5) of said feedback op-amp;
and wherein
the vibration signal (50) is fed into said one of said input terminals of said feedback op-amp;

whereby a conditioned output signal from said output terminal (7) of said feedback op-amp (U2) drives and causes an impedance change of said transistor (Q1) wherein said impedance change along with an amount of said constant current through said transistor (Q1) provide said conditioned output signal (7) to said second ends of said transmission lines (244, 246) and wherein said feedback loop returns a portion of said conditioned output signal (7) back to said one of said input terminals (6,5) of said feedback op-amp and is merged with the vibration signal (50) such that said conditioned output (7) signal is indicative of the magnitude of vibration being monitored.

**2.** The circuit of claim 1 wherein said one of said input terminals is said inverting input terminal (6) of said feedback op-amp (U2).

**3.** The circuit of claim 2, further including a sensor (20) operatively coupled to a source of vibration and generating the vibration signal (50).

4.  The circuit of claim 3, wherein said sensor (20) includes:

    a piezoelectric crystal (12) operatively coupled between a sensor base (14) and an inertial reference mass (IM) ;
    the source of vibration causes a compression or tension force to act on said piezoelectric crystal (12) wherein said piezoelectric crystal acts as a precision spring to oppose compression or tension forces thereby generating the vibration signal (50) having a frequency equal to the vibration frequency of the source of vibration and whose amplitude is proportional to the magnitude of acceleration of the source of vibration.

5.  The circuit of claim 4, further including means for providing a constant DC voltage to said second ends of said transmission lines (244, 246).

6.  The circuit of claim 5 wherein said means for providing a constant DC voltage to said second ends of said transmission lines includes a first zener diode operatively coupled to said second ends of said transmission lines (244, 246).

7.  The circuit of claim 6 wherein said means for providing a constant DC voltage to said second ends of said transmission lines (244, 246) further includes:

    a first branch including a first resistance means connected in series with said first zener diode;
    said first branch operatively coupled to said second ends of said transmission lines; and
    said power source providing a constant current to said first zener diode through said first resistance means for biasing said first zener diode to function as a stable DC voltage regulator providing a regulated voltage.

8.  The circuit of claim 7 wherein said means for providing a constant DC voltage to said second ends of said transmission lines further includes :

    said noninverting input terminal (5) of said feedback op-amp operatively coupled to an intersection of said first resistance means and said first zener diode whereby said regulated voltage is applied to said noninverting input terminal of said feedback op-amp; and
    means integrally formed within said feedback op-amp for applying said regulated voltage to said inverting input terminal (6) of said feedback op-amp.

9.  The circuit of claim 8 wherein said means for providing a constant DC voltage to said second ends of said transmission lines (244, 246) further includes:

    a voltage divider network having a second branch including a plurality of serially connected resistors;
    said second branch operatively coupled to said second ends of said transmission lines; and
    a fourth resistor having a first end connected to said inverting input (6) of said feedback op-amp, and a second end connected to an intersection of two of said plurality of serially connected resistors of said second branch.

10. The circuit of claim 9 wherein said means for providing a constant DC voltage to said second ends of said transmission lines further includes:

    means for substantially disallowing DC current flow through said fourth resistor, thereby allowing said regulated voltage at said inverting input of said feedback op-amp and said first end of said fourth resistor to appear at said second end of said fourth resistor and across at least one of said plurality of serially connected resistors.

11. The circuit of claim 10 wherein said regulated voltage across at least one of said plurality of serially connected resistors draws a constant current through said second branch thereby providing said constant DC voltage to said second ends of said transmission lines.

12. The circuit of claim 11, further including a gain stage op-amp (U1) interposed between and operatively coupled to said sensor (22) and said feedback op-amp (U2) wherein said gain stage amplifies the vibration signal (50) and said feedback loop of said feedback op-amp includes a capacitance providing means associated with said feedback op-amp for integrating the vibration signal.

13. The circuit of claim 12 wherein said gain stage op-amp includes a noninverting input terminal (3) operatively coupled

**EP 0 720 728 B1**

to a first output terminal of said sensor and an inverting input terminal (2) operatively coupled to a second output terminal of said sensor.

14. The circuit of claim 13 wherein said gain stage op-amp further includes an output terminal (1) connected to said inverting terminal of said feedback op-amp through a capacitance and an adjustable resistance.

15. The circuit of claim 14 wherein said gain stage op-amp (U1) further includes a closed loop including a capacitance and a resistance connected in parallel and coupled between said output terminal and said inverting input terminal of said gain stage op-amp.

16. The circuit of claim 15 wherein said gain stage op-amp further includes power supply bias terminals operatively coupled to said power supply bias terminals of said feedback op-amp (U2).

17. The circuit of claim 16 wherein said power supply bias terminals of said gain stage op-amp and said feedback op-amp are operatively coupled to said second ends of said transmission lines whereby said constant DC voltage across said second ends of said transmission lines provides a stable DC bias voltage for said gain stage op-amp and said feedback op-amp; and power supply rejection means integrally formed within said gain stage op-amp and said feedback op-amp;
whereby the conditioned vibration signal from said transistor rides on top of said constant DC voltage across said second ends of said transmission lines.

18. The circuit of claim 16 wherein said power supply bias terminals of said gain stage op-amp and said feedback op-amp are operatively coupled across a second zener diode;
said second zener diode is coupled in series with a second resistance means and said second resistance means and said second zener diode are operatively coupled across said second ends of said transmission lines;
said power source providing a constant current to said second zener diode through said second resistance means for biasing said second zener diode to function as a stable DC voltage regulator providing a regulated DC voltage to said power supply bias terminals of said gain stage op-amp and said feedback op-amp.

19. The circuit of claim 11, further including an integrating op-amp interposed between and operatively coupled to said sensor and said feedback op-amp wherein said integrating op-amp (U1) integrates the vibration signal (50) and said feedback loop of said feedback op-amp (U2) includes resistance means associated with said feedback op-amp for amplifying the vibration signal.

20. The circuit of claim 19 wherein said integrating op-amp (U1) includes a noninverting input (2) operatively coupled to a first terminal of said sensor and an inverting input operatively coupled to a second terminal of said sensor (22) through a resistance.

21. The circuit of claim 20 wherein said integrating op-amp further includes an output terminal connected to said inverting terminal of said feedback op-amp through a capacitance and adjustable resistance.

22. The circuit of claim 21 wherein said integrating op-amp (U1) further includes a closed loop including a capacitance coupled between said inverting input (2) and said output (71) of said integrating op-amp.

23. The circuit of claim 22 wherein said integrating op-amp (U1) further includes power supply bias terminals (4,8) operatively coupled to said power supply bias terminals of said feedback op-amp.

24. The circuit of claim 23 wherein said power supply bias terminals of said integrating op-amp and said feedback op-amp are operatively coupled to said second ends of said transmission lines whereby said constant DC voltage between said second ends of said'transmission lines provides a stable DC bias voltage for said integrating op-amp and said feedback op-amp; and power supply rejection means integrally formed within said gain stage op-amp and said feedback op-amp;
whereby the conditioned vibration signal from said transistor rides on top of said constant DC voltage across said second ends of said transmission lines.

25. The circuit of claim 11, further including a charged coupled differential amplifier stage interposed between and operatively coupled to said sensor (22) and said feedback op-amp (U2).

**26.** The circuit of claim 25 wherein said charged coupled differential amplifier stage includes means to convert the vibration signal (50) in terms of charge to a vibration signal in terms of voltage.

**27.** The circuit of claim 26 wherein said converting means includes an op-amp having at least one input terminal operatively coupled to at least one capacitor and to at least one output terminal of said sensor whereby a charge produced by said sensor produces a voltage across at least one said capacitor.

**Patentansprüche**

**1.** Schaltungsanordnung (100) zur Verarbeitung eines Vibrationssignals (50) in einer eine Vibration überwachenden Einrichtung mit:

einer Leistungsquelle (80) zur Erzeugung eines konstanten Stroms;
einer Mehrzahl von Übertragungsleitungen (244, 246) mit ersten Enden und zweiten Enden;
wobei die ersten Enden der Übertragungsleitungen mit der den konstanten Strom erzeugenden Leistungsquelle (80) verbunden sind;
einem Transistor (Q1), der mit den zweiten Enden der Übertragungsleitungen verbunden ist;
einem Rückkopplungs-Operationsverstärker (U2) mit einem invertierenden Eingangsanschluß (6), einem nichtinvertierenden Eingangsanschluß (5), einem Ausgangsanschluß (7) und Leistungsversorgungs-Vorspannungs-Anschlüssen (4, 8);
wobei der Ausgangsanschluß des Rückkopplungs-Operationsverstärkers mit dem Transistor verbunden ist;
einer Rückkopplungs-Schleife von dem Ausgangsanschluß (7) des Rückkopplungs-Operationsverstärkers (U2) durch den Transistor (Q1) und zu einem der Eingangsanschlüsse (6, 5) des Rückkopplungs-Operationsverstärkers;

und wobei
das Vibrationssignal (50) an einen der Eingangsanschlüsse des Rückkopplungs-Operationsverstärkers geführt ist;
so dass ein konditioniertes Ausgangssignal von dem Ausgangsanschluß (7) des Rückkopplungs-Operationsverstärkers (U2) den Transistor (Q1) treibt und eine Impedanzänderung des Transistors (Q1) bewirkt, wobei die Impedanzänderung zusammen mit einem Betrag des konstanten Stroms durch den Transistor (Q1) das konditionierte Ausgangssignal (7) an den zweiten Enden der Übertragungsleitungen (244, 246) zur Verfügung stellt und wobei die Rückkopplungsschleife einen Teil des konditionierten Ausgangssignals (7) zurück zu dem einen der Eingangsanschlüsse (6, 5) des Rückkopplungs-Operationsverstärkers führt und mit dem Vibrationssignal (50) in der Weise kombiniert wird, dass das konditionierte Ausgangssignal (7) die Größe der überwachten Vibration anzeigt.

**2.** Schaltungsanordnung nach Anspruch 1,
bei der der eine der Eingangsanschlüsse der invertierte Eingangsanschluß (6) des Rückkopplungs-Operationsverstärkers (U2) ist.

**3.** Schaltungsanordnung nach Anspruch 2,
mit einem Sensor (20), der mit einer Quelle der Vibration verbunden ist und das Vibrationssignal (50) erzeugt.

**4.** Schaltungsanordnung nach Anspruch 3,
bei der der Sensor (20) umfasst:

einen piezoelektrischen Kristall (12), der zwischen eine Sensorbasis (14) und eine Trägheits-Bezugsmasse (IM) geschaltet ist; wobei
die Quelle der Vibration bewirkt, dass eine Druck- oder Zugkraft auf den piezoelektrischen Kristall (12) einwirkt und wobei der piezoelektrische Kristall als Präzisionsfeder den Druck- oder Zugkräften entgegenwirkt und dadurch das Vibrationssignal (50) erzeugt, dessen Frequenz gleich der Vibrationsfrequenz der Quelle der Vibration und dessen Amplitude proportional zu der Größe der Beschleunigung der Quelle der Vibration ist.

**5.** Schaltungsanordnung nach Anspruch 4,
mit einem Mittel zum Anlegen einer konstanten Gleichspannung an die zweiten Enden der Übertragungsleitungen (244, 246).

**6.** Schaltungsanordnung nach Anspruch 5,

bei der das Mittel zum Anlegen einer konstanten Gleichspannung an die zweiten Enden der Übertragungsleitungen eine erste Zenerdiode umfasst, die mit den zweiten Enden der Übertragungsleitungen (244, 246) verbunden ist.

7. Schaltungsanordnung nach Anspruch 6,
bei der das Mittel zum Anlegen einer konstanten Gleichspannung an die zweiten Enden der Übertragungsleitungen (244, 246) umfasst:

einen ersten Zweig mit einem ersten Widerstandsmittel, das in Serie mit der ersten Zenerdiode geschaltet ist; wobei
der erste Zweig mit den zweiten Enden der Übertragungsleitungen verbunden ist; und
die Leistungsquelle der ersten Zenerdiode einen konstanten Strom durch das erste Widerstandsmittel zuführt, um die erste Zenerdiode vorzuspannen, so dass diese als stabiler Gleichspannungsregler arbeitet und eine geregelte Spannung erzeugt.

8. Schaltungsanordnung nach Anspruch 7,
bei der das Mittel zum Anlegen einer konstanten Gleichspannung an die zweiten Enden der Übertragungsleitungen ferner beinhaltet:

der nichtinvertierende Eingangsanschluß (5) des Rückkopplungs-Operationsverstärkers ist mit einem Knotenpunkt des ersten Widerstandsmittels und der ersten Zenerdiode verbunden, so dass die geregelte Spannung an dem nichtinvertierenden Eingangsanschluß des Rückkopplungs-Operationsverstärkers anliegt; und
integral mit dem Rückkopplungs-Operationsverstärker ausgebildete Mittel zum Anlegen der geregelten Spannung an den invertierenden Eingangsanschluß (6) des Rückkopplungs-Operationsverstärkers.

9. Schaltungsanordnung nach Anspruch 8,
bei der das Mittel zum Anlegen einer konstanten Gleichspannung an die zweiten Enden der Übertragungsleitungen (244, 246) ferner umfasst:

ein Spannungsteiler-Netzwerk mit einem zweiten Zweig mit einer Mehrzahl von seriell geschalteten widerständen;
wobei der zweite Zweig mit den zweiten Enden der Übertragungsleitungen verbunden ist; und
einen vierten widerstand mit einem ersten Ende, das mit dem invertierenden Eingang (6) des Rückkopplungs-Operationsverstärkers verbunden ist, sowie einem zweiten Ende, das mit einem Knotenpunkt von zwei der Mehrzahl von seriell geschalteten Widerständen des zweiten Zweiges verbunden ist.

10. Schaltungsanordnung nach Anspruch 9,
bei der das Mittel zum Anlegen einer konstanten Gleichspannung an die zweiten Enden der Übertragungsleitungen umfasst:

ein Mittel, mit dem im wesentlichen verhindert wird, dass ein Gleichstrom durch den vierten widerstand fließt, so dass die geregelte Spannung an dem invertierenden Eingang des Rückkopplungs-Operationsverstärkers und dem ersten Ende des vierten Widerstandes an dem zweiten Ende des vierten Widerstandes und über mindestens einem der Mehrzahl von seriell geschalteten Widerständen anliegen kann.

11. Schaltungsanordnung nach Anspruch 10,
bei der die geregelte Spannung über mindestens einem der Mehrzahl von seriell geschalteten Widerständen einen konstanten Strom durch den zweiten Zweig zieht, so dass die konstante Gleichspannung an den zweiten Enden der Übertragungsleitungen zur Verfügung gestellt wird.

12. Schaltungsanordnung nach Anspruch 11,
mit einem Operationsverstärker (U1) mit einer Verstärkerstufe, der zwischen den Sensor (22) und den Rückkopplungs-Operationsverstärker (U2) geschaltet und mit diesem verbunden ist, wobei die Verstärkerstufe das Vibrationssignal (50) verstärkt und die Rückkopplungsschleife des Rückkopplungs-Operationsverstärkers eine Kapazität aufweist, die in Verbindung mit dem Rückkopplungs-Operationsverstärker Mittel zum Integrieren des Vibrationssignals zur Verfügung stellt.

13. Schaltungsanordnung nach Anspruch 12,
bei der der Operationsverstärker mit der Verstärkerstufe einen nichtinvertierenden Eingangsanschluß (3) aufweist, der mit einem ersten Ausgangsanschluß des Sensors und einem mit einem zweiten Ausgangsanschluß des Sensors verbundenen invertierenden Eingangsanschluß (2) verbunden ist.

**14.** Schaltungsanordnung nach Anspruch 13,
bei der der Operationsverstärker mit der Verstärkerstufe einen Ausgangsanschluß (1) aufweist, der über eine Kapazität und einen einstellbaren Widerstand mit dem invertierenden Eingang des Rückkopplungs-Operationsverstärkers verbunden ist.

**15.** Schaltungsanordnung nach Anspruch 14,
bei der der Operationsverstärker (U1) mit der Verstärkerstufe eine geschlossene Schleife aufweist, die eine Kapazität und einen Widerstand, die parallel geschaltet sind, umfasst und die zwischen den Ausgangsanschluß und den invertierenden Eingangsanschluß des Operationsverstärkers mit der Verstärkerstufe geschaltet ist.

**16.** Schaltungsanordnung nach Anspruch 15,
bei der der Operationsverstärker mit der Verstärkerstufe Leistungsversorgungs-Vorspannungsanschlüsse umfaßt, die mit den Leistungsversorgungs-Vorspannungsanschlüssen des Rückkopplungs-Operationsverstärkers (U2) verbunden sind.

**17.** Schaltungsanordnung nach Anspruch 16,
bei der die Leistungsversorgungs-Vorspannungsanschlüsse des Operationsverstärkers mit der Verstärkerstufe und des Rückkopplungs-Operationsverstärkers mit den zweiten Enden der Übertragungsleitungen verbunden sind, so dass die konstante Gleichspannung über den zweiten Enden der Übertragungsleitungen eine stabile DC-Vorspannung für den Operationsverstärker mit der Verstärkerstufe und den Rückkopplungs-Operationsverstärker zur Verfügung stellt; und
bei der integral in dem Operationsverstärker mit der Verstärkerstufe und dem Rückkopplungs-Operationsverstärker Unterdrückungseinrichtungen für die Leistungsversorgung ausgebildet sind; so dass
das konditionierte Vibrationssignal aus dem Transistor auf die Spitze der konstanten Gleichspannung über den zweiten Enden der Übertragungsleitungen aufgesetzt ist.

**18.** Schaltungsanordnung nach Anspruch 16,
bei der die Leistungsversorgungs-Vorspannungsanschlüsse des Operationsverstärkers mit der Verstärkerstufe und des Rückkopplungs-Operationsverstärkers über eine zweite Zenerdiode verbunden sind; wobei
die zweite Zenerdiode in Serie mit einem zweiten Widerstandsmittel geschaltet ist und das zweite Widerstandsmittel und die zweite Zenerdiode über die zweiten Enden der Übertragungsleitungen verbunden sind; und wobei
die Leistungsversorgung der zweiten Zenerdiode einen konstanten Strom über das zweite Widerstandsmittel zum Vorspannen der zweiten Zenerdiode zuführt, so dass diese als ein stabiler Gleichspannungsregler arbeitet, der eine geregelte Gleichspannung an den Leistungsversorgungs-Vorspannungsanschlüssen des Operationsverstärkers mit der Verstärkerstufe und des Rückkopplungs-Operationsverstärkers zur Verfügung stellt.

**19.** Schaltungsanordnung nach Anspruch 11,
mit einem integrierenden Operationsverstärker, der zwischen den Sensor und den Rückkopplungs-Operationsverstärker geschaltet und mit diesem verbunden ist, wobei der integrierende Operationsverstärker (U1) das Vibrationssignal (50) integriert und die Rückkopplungsschleife des Rückkopplungs-Operationsverstärkers (U2) ein mit dem Rückkopplungs-Operationsverstärker verbundenes Widerstandsmittel zum Verstärken des Vibrationssignals umfasst.

**20.** Schaltungsanordnung nach Anspruch 19,
bei der der integrierende Operationsverstärker (U1) einen nichtinvertierenden Eingang (2), der mit einem ersten Anschluß des Sensors verbunden ist, sowie einen invertierenden Eingang aufweist, der über einen Widerstand mit einem zweiten Anschluß des Sensors (22) verbunden ist.

**21.** Schaltungsanordnung nach Anspruch 20,
bei der der integrierende Operationsverstärker einen Ausgangsanschluß aufweist, der über eine Kapazität und einen einstellbaren Widerstand mit dem invertierenden Anschluß des Rückkopplungs-Operationsverstärker verbunden ist.

**22.** Schaltungsanordnung nach Anspruch 21,
bei der der integrierende Operationsverstärker (U1) eine geschlossene Schleife mit einer Kapazität aufweist, die zwischen den invertierenden Eingang (2) und den Ausgang (71) des integrierenden Operationsverstärkers geschaltet ist.

23. Schaltungsanordnung nach Anspruch 22,
bei der der integrierende Operationsverstärker (U1) Leistungsversorgungs-Vorspannungsanschlüsse (4, 8) aufweist, die mit den Leistungsversorgungs-Vorspannungsanschlüssen des Rückkopplungs-Operationsverstärkers verbunden sind.

24. Schaltungsanordnung nach Anspruch 23,
bei der die Leistungsversorgungs-Vorspannungsanschlüsse des integrierenden Operationsverstärkers und des Rückkopplungs-Operationsverstärktes mit den zweiten Enden der Übertragungsleitungen verbunden sind, so dass die konstante Gleichspannung zwischen den zweiten Enden der Übertragungsleitungen eine stabile DC-Vorspannung für den integrierenden Operationsverstärker und den Rückkopplungs-Operationsverstärker zur Verfügung stellt; und
bei der integral in dem Operationsverstärker mit der Verstärkerstufe und dem Rückkopplungs-Operationsverstärker Unterdrückungseinrichtungen für die Leistungsversorgung ausgebildet sind; so dass
das konditionierte Vibrationssignal aus dem Transistor auf die Spitze der konstanten Gleichspannung über den zweiten Enden der Übertragungsleitungen aufgesetzt ist.

25. Schaltungsanordnung nach Anspruch 11,
mit einer ladungsgekoppelten Differentialverstärkerstufe, die zwischen den Sensor (22) und den Rückkopplungs-Operationsverstärker (U2) geschaltet und mit diesem verbunden ist.

26. Schaltungsanordnung nach Anspruch 25,
bei der die ladungsgekoppelte Differentialverstärkerstufe ein Mittel zum Konvertieren des Vibrationssignals (50) in Form einer Ladung in ein Vibrationssignal in Form einer Spannung aufweist.

27. Schaltungsanordnung nach Anspruch 26,
bei der das konvertierende Mittel einen Operationsverstärker mit mindestens einem Eingangsanschluß aufweist, der mit mindestens einem Kondensator und mindestens einem Ausgangsanschluß des Sensors verbunden ist, so dass eine durch den Sensor erzeugte Ladung eine Spannung über mindestens einem Kondensator erzeugt.

**Revendications**

1. Circuit (100) pour traiter un signal de vibration (50) dans un dispositif d'analyse des vibrations comprenant en association :

une source d'alimentation (80), procurant un courant constant ;
une série de lignes de transmission (244, 246) ayant des premières extrémités et des deuxièmes extrémités ;
lesdites premières extrémités desdites lignes de transmission étant efficacement couplées à la source d'alimentation de courant constant (80) ;
un transistor (Q1) efficacement couplé auxdites deuxièmes extrémités desdites lignes de transmission :

un amplificateur opérationnel a réaction (U2) ayant une borne d'entrée inverseuse (6), une borne d'entrée non inverseuse (5), une borne de sortie (7) et des bornes réseau de polarisation (4, 8) ;
ladite borne de sortie dudit ampli op à réaction étant efficacement couplée audit transistor ;
une boucle de réaction de la borne de sortie (7) dudit ampli op à réaction (U2), par ledit transistor (Q1) et à l'une des bornes d'entrée (6, 5) dudit ampli op à réaction, et dans lequel
le signal de vibration (50) est alimenté à l'une desdites bornes d'entrée dudit ampli op à réaction ;
ce par quoi un signal de sortie conditionné de la borne de sortie (7) dudit ampli op à réaction (U2) commande et provoque une variation d'impédance dudit transistor (Q1), où ladite variation d'impédance avec une quantité dudit courant constant par ledit transistor (Q1) procure ledit signal de sortie conditionné (7) aux deuxièmes extrémités desdites lignes de transmission (244, 246) et où ladite boucle de réaction retourne une partie dudit signal de sortie conditionné (7) à nouveau vers l'une desdites bornes d'entrée (6, 5) dudit ampli op à réaction et est fusionnée au signal de vibration (50) de telle sorte que le signal de sortie conditionné (7) indique l'amplitude de la vibration à analyser.

**2.** Circuit suivant la revendication 1, dans lequel l'une des bornes d'entrée est ladite borne d'entrée inverseuse (6) dudit ampli op à réaction (U2).

**3.** Circuit suivant la revendication 2, comprenant en outre, un capteur (20) couplé efficacement à une source de vibration et générant le signal de vibration (50).

**4.** Circuit suivant la revendication 3, dans lequel ledit capteur (20) comprend :

un cristal piézoélectrique (12) couplé entre une base de capteur (14) et un massif antivibratoire (IM) de référence ;
la source de la vibration provoque une force de compression ou de tension pour agir sur ledit cristal piézoélectrique (12) où ledit cristal piézoélectrique agit comme un ressort de précision pour s'opposer aux forces de compression ou de tension ce par quoi on génère le signal de vibration (50), ayant une fréquence égale à la fréquence de vibration de la source de vibration et dont l'amplitude est proportionnelle à l'amplitude de l'accélération de la source de vibration.

**5.** Circuit suivant la revendication 4, comprenant en outre, un moyen pour procurer une tension DC constante aux dites deuxièmes extrémités desdites lignes de transmission (244, 246).

**6.** Circuit suivant la revendication 5, où ledit moyen pour procurer une tension DC constante aux dites deuxièmes extrémités desdites lignes de transmission, comprend une première diode de Zener couplée efficacement aux dites deuxièmes extrémités desdites lignes de transmission (244, 246).

**7.** Circuit suivant la revendication 6, où ledit moyen pour procurer une tension DC constante aux dites deuxièmes extrémités desdites lignes de transmission (244, 246), comprend en outre :

une première ramification comprenant un premier moyen de résistance connecté en série avec ladite première diode de Zener ;
ladite première ramification étant couplée efficacement aux dites deuxièmes extrémités desdites lignes de transmission, et
ladite source d'alimentation procurant un courant constant à ladite première diode de Zener par ledit premier moyen de résistance pour polariser ladite première diode de Zener de manière à fonctionner comme un régulateur stable de la tension DC procurant une tension régulée.

**8.** Circuit suivant la revendication 7, où ledit moyen pour procurer une tension DC constante aux dites deuxièmes extrémités desdites lignes de transmission comprend en outre :

ladite borne d'entrée inverseuse (5) dudit ampli op à réaction, couplée efficacement à une intersection dudit premier moyen de résistance et à ladite première diode de Zener, ce par quoi ladite tension régulée est appliquée à ladite borne d'entrée non inverseuse dudit ampli op à réaction, et
un moyen formé de manière intégrale, dans ledit ampli op à réaction pour appliquer ladite tension régulée à ladite borne d'entrée inverseuse (6) dudit ampli op à réaction.

**9.** Circuit suivant la revendication 8, où ledit moyen pour procurer une tension DC constante aux dites deuxièmes extrémités desdites lignes de transmission (244, 246), comprend en outre :

un réseau réducteur de tension ayant une deuxième dérivation comprenant une série de résistances connectées en série ;
ladite deuxième dérivation couplée efficacement aux dites deuxièmes extrémités desdites lignes de transmission, et
une quatrième résistance ayant une première extrémité connectée à ladite entrée inverseuse (6) dudit ampli op à réaction, et une deuxième extrémité connectée à une intersection de deux de ladite série de résistances connectées en série de ladite deuxième dérivation.

**10.** Circuit suivant la revendication 9, où ledit moyen pour procurer une tension DC constante aux dites deuxièmes extrémités desdites lignes de transmission comprend en outre :

un moyen pour sensiblement empêcher la circulation du courant DC au travers de ladite quatrième résistance, pour ainsi permettre à ladite tension régulée de ladite entrée inverseuse dudit ampli op à réaction et de ladite première extrémité de ladite quatrième résistance pour apparaître à ladite deuxième extrémité de ladite quatrième résistance et au travers d'au moins l'une de la série des résistances connectées en série.

**11.** Circuit suivant la revendication 10, dans lequel ladite tension régulée au travers d'au moins l'une de la série des résistances connectées en série tire un courant constant au travers de la deuxième dérivation pour ainsi procurer ladite tension DC constante aux dites deuxièmes extrémités des lignes de transmission.

**12.** Circuit suivant la revendication 11, comprenant en outre, un ampli op (U1) d'étape de gain interposé entre et couplé efficacement audit capteur (22) et ledit ampli op à réaction (U2), dans lequel l'étape de gain amplifie le signal de vibration (50) et ladite boucle de réaction dudit ampli op à réaction comprend une capacitance procurant un moyen associé audit ampli op à réaction pour intégrer le signal de vibration.

**13.** Circuit suivant la revendication 12, dans lequel ledit ampli op d'étape de gain comprend une borne d'entrée non inverseuse (3) couplée efficacement à une première borne de sortie dudit capteur et une borne d'entrée inverseuse (2) couplée efficacement à une deuxième borne de sortie dudit capteur.

**14.** Circuit suivant la revendication 13, dans lequel ledit ampli op d'étape de gain comprend en outre une borne de sortie (1) connectée à ladite borne inverseuse dudit ampli op à réaction par une capacitance et une résistance ajustable.

**15.** Circuit suivant la revendication 14, dans lequel ledit ampli op d'étape de gain (U1) comprend en outre une boucle fermée comprenant une capacitance et une résistance connectée en parallèle et couplée entre ladite borne de sortie et ladite borne d'entrée inverseuse dudit ampli op d'étape de gain.

**16.** Circuit suivant la revendication 15, dans lequel ledit ampli op d'étape de gain comprend en outre des bornes réseau de polarisation couplées efficacement aux dites bornes réseau de polarisation dudit ampli op à réaction (U2).

**17.** Circuit suivant la revendication 16, dans lequel lesdites bornes réseau de polarisation dudit ampli op d'étape de gain et dudit ampli op à réaction sont couplées efficacement aux dites deuxièmes extrémités desdites lignes de transmission, ce par quoi ladite tension DC constante au travers desdites deuxièmes extrémités desdites lignes de transmission procure une tension DC stable de polarisation pour ledit ampli op d'étape de gain et dudit ampli op à réaction, et un moyen de rejet d'alimentation formé d'une pièce dans ledit ampli op d'étape de gain et dudit ampli op à réaction ;
ce par quoi le signal de vibration conditionné dudit transistor monte au sommet de ladite tension DC constante au travers des deuxièmes extrémités desdites lignes de transmission.

**18.** Circuit suivant la revendication 16, dans lequel lesdites bornes réseau de polarisation dudit ampli op d'étape de gain et dudit ampli op à réaction sont couplées efficacement au travers d'une deuxième diode de Zener ;
ladite deuxième diode de Zener est couplée en série avec un deuxième moyen de résistance et ledit deuxième moyen de résistance et ladite deuxième diode de Zener sont couplés efficacement au travers des deuxièmes extrémités desdites lignes de transmission ;
ladite source d'alimentation procurant n courant constant à ladite deuxième diode de Zener par le deuxième moyen de résistance pour polariser ladite deuxième électrode de Zener, de manière à fonctionner comme un régulateur de tension DC stable procurant une tension DC régulée aux dites bornes réseau de polarisation dudit ampli op d'étape de gain et ampli op à réaction.

**19.** Circuit suivant la revendication 11, comprenant en outre un ampli op intégrant interposé entre et couplé efficacement audit capteur et audit ampli op à réaction, où ledit ampli op intégrant (U1) intègre le signal de vibration (50) et ladite boucle de réaction dudit ampli op à réaction (U2) comprend un moyen de résistance associé audit ampli op à réaction pour amplifier le signal de réaction.

**20.** Circuit suivant la revendication 19, dans lequel ledit ampli op intégrant (U1) comprend une entrée inverseuse (2) couplée efficacement à une première borne dudit capteur et une entrée inverseuse couplée efficacement à une deuxième borne dudit capteur (22) par une résistance.

**21.** Circuit suivant la revendication 20, dans lequel ledit ampli op intégrant comprend en outre une borne de sortie connectée à ladite borne inverseuse dudit ampli op à réaction par une capacitance et une résistance ajustable.

**22.** Circuit suivant la revendication 210, dans lequel ledit ampli op intégrant (U1) comprend en outre une boucle fermée comprenant une capacitance couplée entre l'entrée inverseuse (2) et ladite sortie (71) dudit ampli op intégrant.

**23.** Circuit suivant la revendication 22, dans lequel ledit ampli op intégrant (U1) comprend en outre des bornes réseau de polarisation (4, 8) couplées efficacement aux dites bornes réseau de polarisation dudit ampli op à réaction.

**24.** Circuit suivant la revendication 23, dans lequel lesdites bornes réseau de polarisation dudit ampli op intégrant et dudit ampli op à réaction sont couplées efficacement aux dites deuxièmes extrémités desdites lignes de transmission, ce par quoi ladite tension DC constante entre lesdites deuxièmes extrémités desdites lignes de transmission procure une tension DC stable de polarisation dudit ampli op intégrant et dudit ampli op à réaction, et un moyen de rejet d'alimentation formé d'une pièce dans ledit ampli op d'étape de gain et dudit ampli op à réaction ;
ce par quoi le signal de vibration conditionné dudit transistor monte au sommet de ladite tension DC constante au travers des deuxièmes extrémités desdites lignes de transmission.

**25.** Circuit suivant la revendication 11, comprenant en outre, un étage chargé d'amplificateur différentiel couplé interposé entre et couplé efficacement audit capteur (22) et audit ampli op à réaction (U2).

**26.** Circuit suivant la revendication 25, dans lequel ledit étage chargé d'amplificateur différentiel couplé comprend un moyen pour convertir le signal de vibration (50) en termes de charge en un signal de vibration en termes de tension.

**27.** Circuit suivant la revendication 26, dans lequel ledit moyen de conversion comprend un ampli op ayant au moins une borne d'entrée couplée efficacement à au moins un capacitance et à au moins une borne de sortie dudit capteur, ce par quoi une charge produite par ledit capteur produit une tension au travers de ladite au moins une capacitance.

Fig. 1

Fig. 2

*Fig. 3*

EP 0 720 728 B1

Fig. 4

Fig. 5

Fig. 6

EP 0 720 728 B1